Europäisches Patentamt

European Patent Office

Office européen des brevets

(19)

(11)  **EP 1 689 059 A1**

(12)  **EUROPEAN PATENT APPLICATION**
published in accordance with Art. 158(3) EPC

(43) Date of publication:
    **09.08.2006  Bulletin 2006/32**

(51) Int Cl.:
    *H02J 3/01* (2006.01)        *H02M 1/12* (2006.01)

(21) Application number: **03819336.3**

(22) Date of filing: **27.11.2003**

(86) International application number:
    **PCT/KZ2003/000006**

(87) International publication number:
    **WO 2005/002021 (06.01.2005 Gazette 2005/01)**

(84) Designated Contracting States:
    **CH GB LI SE**

(30) Priority:  **30.06.2003  KZ 030033**

(71) Applicant: **Stetzer, David A.**
    **Blair, WI 54616 (US)**

(72) Inventor: **The designation of the inventor has not yet been filed**

(74) Representative: **Hano, Christian et al**
    **v. Füner Ebbinghaus Finck Hano**
    **Mariahilfplatz 2 & 3**
    **81541 München (DE)**

(54)  **SUPPLY-LINE FILTER**

(57)  The utility model refers to electric equipment, in particular to filters for suppression and exclusion of high-frequency electromagnetic components in power alternating current networks of commercial frequency.

The technical result to be achieved by the use of the utility model is a significant decrease in the amplitude of the high-frequency electromagnetic component of voltage in the frequency range of 1-100 kHz, as well as simplification and reduction of filter dimensions.

The specified technical result is achieved by the supply-line filter containing a condenser and a resistor in which a non-inductive thin-film condenser is used to which the resistor is connected in parallel. In the filter are mainly used a condenser with a capacity of 5-30 $\mu$F and a resistor with a resistance of 20-100 k$\Omega$.

EP 1 689 059 A1

**Description**

The utility model refers to electric equipment, in particular to filters for suppression or elimination of high-frequency electromagnetic components in circuits of alternate power current of commercial frequency.

Supply-line interference suppressing filters are known on discrete elements which include a condenser and an inductance coil /Technical Conditions MRTU 45- 1110-67(Russia)/. Since these filters are designated to suppression of interference in the feeding circuits with voltages of up to several hundreds of volts and with currents of up to several amperes, condensers and coils of such filters have large dimensions, weight and price. The rated capacity of condensers used in these filters amounts to 0.5-1.0 $\mu$F, which leads to large currents of filter leak and significantly increases the starting current upon supply of the voltage of the supply main to the filter. Besides, these filters provide mainly attenuation of disturbances with frequencies of over 1MHz, while the efficiency of the filter is insignificant at the lower frequency ranges within the limits of 1-100 kHz.

There are known filters in which the coil and condenser are combined constructively and electrically since the coil is made of metal band which at the same time is one of the condenser plates. For example, a filter for disturbance suppression according to US Patent 4563658, Int. Cl. H 03 H 7/01, 1986 consists of two metal bands and alternate dielectric spacers being put one over another and rolled in a coil. One metal band is provided with electric outputs at both ends; it plays the role of the inductance coil and at the same time serves as one of the condenser plates. The second band serves as another plate which acts as ferromagnetic core for the first band increasing its inductance. The rated capacity of the condenser of this filter is equal to 0,01 $\mu$F. Such constructive design of the filter significantly decreases weight and dimensions of the filter upon high efficiency of its operation at high and very high frequency, however efficiency of the filter is low at the lower frequency ranges.

The filter according to Certificate of Authorship 1488918 (USSR), Int. Cl. H 02 J 3/01, 1/02, 1989/ is the closest prior art of the utility model which contains a reactor (inductance), a condenser and a resistor, the first outputs of which are connected into star and the second outputs of the condenser and reactor are connected to the circuit and autotransformer, the intermediate output of which is connected to the clamp of the circuit connected with the reactor. Availability of the autotransformer in the structure of the filter reduces power losses, however it increases the dimensions of the filter and its weight. Similar to previously considered analogues, this structure is not efficient enough upon filtration in the frequency range of 1-100 kHz.

The problem underlying the present utility model is to provide a device allowing elimination of a high-frequency electromagnetic component of voltage relating to the range of 1-100 kHz in networks having alternate power current of commercial frequency. Known filters eliminate mainly a high-frequency component of power having the frequency of more than 1 MHz and introducing disturbances which complicate the operation of equipment switched to the network such as radio and TV devices or computers, however, they do not much influence the low-frequency range of disturbances. At the same time just the low frequency range of electromagnetic oscillations with lower capacity to attenuation depending on the distance from the source of oscillations more negatively affects the human organism, and elimination of such electromagnetic pollution assists to the formation of favorable environment for human life.

The technical result being achieved by the use of the utility model is a significant decrease in the amplitude of a high-frequency electromagnetic component of voltage in the frequency range of 1-100 kHz, as well as simplification and reduction of the filter dimensions.

The specified technical result should be achieved in the supply-line filter containing condenser and resistor in which a non-inductive thin-film condenser is used to which the resistor is connected in parallel. Advantageously in the filter are used a condenser with a capacity of 5-30 $\mu$F and a resistor having a resistance of 20-100 k$\Omega$.

The use of a non-inductive thin-film condenser in the filter eliminates the possibility of occurrence of resonance in the circuit, which may lead to distortion of the form of a friendly signal. Besides, such condensers are characterized by stable characteristics, durability and small dimensions which increases the reliability of filter operation. A description of such condensers is given in /Standart Handbook for Electrical Engineers. /Donald G. Fink, H. Wayne Peaty -: McGraw-Hill, 14 edition., 1999, 2200 p./. Such condensers were previously used, for example, in operational amplifiers /Integrated circuits and their foreign analogues: Reference book. Volume 2 / □.V.Nefedov - □.: IP RadioSoft, 1999, 640 p./, however, there are no data of their use in supply-line filters.

The shunting resistor is connected to the condenser in parallel which provides more intensive attenuation of low-frequency oscillations in the circuit, since the resistor together with the condenser form an oscillating RC-circuit having a small Q-factor, i.e. having the ability to damp oscillations rather quickly. The use of a condenser with a capacity of 5-30 $\mu$F and a resistor with a resistance of 20-100, as it was determined by tests, allows more efficient elimination of electromagnetic oscillations with a frequency of 1-100 kHz in the alternating current network.

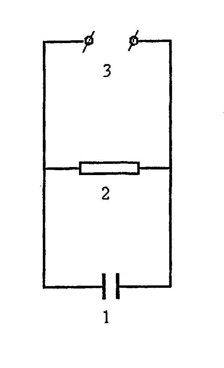

The diagram of the filter is given in fig.1.

The filter includes a condenser 1 and a resistor 2 connected in parallel as well as outputs 3 designated for incorporation into the alternating current network. The filter is constructively made in the form of a cavity casing inside of which condenser and resistor are located, wherein the cavity casing is equipped with outputs for connection to the alternating current network.

The high-frequency electromagnetic component of the voltage is overlapped on the main signal in the alternating current networks with a voltage of 127-220 V and a frequency of 50-60 Hz. This high-frequency component is generated by electric equipment like personal computers, copying machines, printers, facsimile machines, radio and TV devices. Such high-frequency component is the source of electromagnetic oscillations which, along with formation of disturbances for equipment operation, lead to formation of an electromagnetic field which negatively affects the human organism. Electromagnetic oscillations in the ultrahigh frequency range (over 1 MHz) attenuate faster with the distance, therefore oscillations in the range of 1-100 KHz are more hazardous for the human being, since they are less weakened upon an increase of distance from the source of oscillations.

Upon connection of the filter to the network which consists of condenser 1 and resistor 2 connected in parallel, the voltage of the reference frequency and the high-frequency electromagnetic component of the voltage are supplied to the plate of condenser 1. The resistance of the condenser varies for signals having different frequency and may be represented as follows:

$$R = 1 / (2\pi * f * C),$$

where f and □ are signal frequency and condenser capacity, accordingly.

The filter resistance is rather significant for the main network power (127-220 V, 50-60 Hz), and resistance is small for the high-frequency electromagnetic component, which results in a nearly short circuit of the high-frequency component on the condenser and its elimination from the alternating current network. Resistor 2 together with condenser 1 form the oscillating RC-circuit, the duration of transition process of oscillation attenuation in which depends on the value of resistance of resistor 2. It was determined by the tests that it is expedient to use a condenser with a capacity of 5-30 μF and a resistor with a resistance of 20-100 kΩ for most efficient elimination of the high-frequency component of a voltage in the range of 1-100 KHz from the alternating current.

Data related to the amplitude and frequency of the high-frequency component in the alternating current network with a voltage of 220 V and a frequency of 50 Hz are given in the following table as an example without use of the filter and with its connection to the network (the filter including a non-inductive thin-film condenser with a capacity of 10μF and a resistor with a resistance of 50 kΩ).

Table. Results of filter usage in an alternate current network

| Signal frequency, kHz | Signal amplitude without filter usage, V | Signal amplitude upon filter usage, V |
| --- | --- | --- |
| 0,9 | 3,0 | 1,0 |
| 1,2 | 3,0 | 1,0 |
| 1,4 | 3,7 | 1,3 |
| 1,8 | 2,4 | 1,0 |
| 2,2 | 2,0 | 0,4 |
| 2,9 | 3,5 | 1,1 |
| 3,1 | 2,2 | 1,2 |
| 3,6 | 2,9 | 1,8 |
| 4,2 | 2,8 | 1,3 |
| 4,5 | 2,8 | 1,0 |
| 5,5 | 5,8 | 1,5 |
| 7 | 5,8 | 0,2 |
| 10 | 5,8 | 0,0 |
| 12,5 | 5,0 | 0,0 |
| 16,7 | 6,7 | 0,0 |
| 25 | 6,3 | 0,0 |
| 50 | 3.2 | 0,0 |

(continued)

| Signal frequency, kHz | Signal amplitude without filter usage, V | Signal amplitude upon filter usage, V |
|---|---|---|
| 100 | 3.0 | 0,0 |

The results of measurements evidence that attenuation of high-frequency electromagnetic components occurs by 30-50% in the frequency range of 1-5 kHz, and for frequencies higher than 7 kHz, nearly complete attenuation of high-frequency electromagnetic components of the voltage occurs.

**Claims**

1. Supply-line filter including a condenser and a resistor, **characterized in that** it includes a non-inductive thin-film condenser which is connected to the resistor in parallel.

2. Supply-line filter according to claim 1, wherein said condenser has a capacity of 5-30 $\mu$F and resistance of the resistor amounts to 20-100 k$\Omega$.

## INTERNATIONAL SEARCH REPORT

| International application No. |
| --- |
| PCT/KZ 2003/000006 |

**A. CLASSIFICATION OF SUBJECT MATTER**

H02J 3/01, H02M 1/14

According to International Patent Classification (IPC) or to both national classification and IPC

**B. FIELDS SEARCHED**

Minimum documentation searched (classification system followed by classification symbols)

H05K 3/30, H02M 1/12, H05K 3/34, H02M 1/14, H03H 1/02, H04B 15/02, H01G 4/33, H01L 27/01, H02J 3/01

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | US 4227300 A (SIEMENS AKTIENGESELLSCHAFT) Oct. 14, 1980 | 1-2 |
| A | SU 1488918 A1 (INSTITUT ELEKTRODINAMIKI AN USSR) 23.06.1989 | 1-2 |
| A | US 4563658 A (IKEDA TAKESHI) 07. 01. 1986 | 1-2 |
| A | US 5781082 A (ZEXEL CORPORATION) Jul. 14, 1998 | 1-2 |

☐ Further documents are listed in the continuation of Box C.     ☐ See patent family annex.

| | |
| --- | --- |
| *  Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **15 March 2004 (15.03.2004)** | **18 March 2004 (18.03.2004)** |
| Name and mailing address of the ISA/ | Authorized officer |
| Facsimile No. | Telephone No. |

Form PCT/ISA/210 (second sheet) (July 1992)